(19) Europäisches Patentamt
European Patent Office
Office européen des brevets

(11) **EP 3 843 282 B1**

(12) **EUROPEAN PATENT SPECIFICATION**

(45) Date of publication and mention
of the grant of the patent:
**12.04.2023  Bulletin 2023/15**

(21) Application number: **20188269.3**

(22) Date of filing: **28.07.2020**

(51) International Patent Classification (IPC):
**H04B 1/28** *(2006.01)*

(52) Cooperative Patent Classification (CPC):
**H04B 1/28;** H03H 19/002

(54) **SUPERHETERODYNE APPARATUS WITH IMPROVED IMAGE REJECTION**

SUPERHETERODYNE-GERÄT MIT VERBESSERTER UNTERDRÜCKUNG DER SPIEGELFREQUENZ

APPAREIL DE SUPERHÉTÉRODYNE AVEC REJET D'IMAGE AMÉLIORÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.12.2019  US 201916724974**

(43) Date of publication of application:
**30.06.2021  Bulletin 2021/26**

(73) Proprietor: **u-blox AG**
**8800 Thalwil (CH)**

(72) Inventors:
• **McCullagh, Michael J.**
**Cork, Co. Cork T12 E273 (IE)**
• **Frazer, Thomas W.**
**Cork, Co. Cork T12 E273 (IE)**

(74) Representative: **Epping - Hermann - Fischer**
**Patentanwaltsgesellschaft mbH**
**Schloßschmidstraße 5**
**80639 München (DE)**

(56) References cited:
**GB-A- 2 350 953     US-A1- 2007 064 843**

EP 3 843 282 B1

**Description**

## TECHNICAL FIELD

The present invention relates generally to wireless communication systems, in particular to apparatus and methods for image suppression in signals received by radio equipment such as a super-heterodyne receiver.

## BACKGROUND ART

The super-heterodyne is a popular architecture used in wireless communication transceivers because of its robustness and high performance. In a super-heterodyne receiver, also called heterodyne, an incoming radio frequency (RF) signal at a frequency $f_{RF}$ is mixed with a local oscillator (LO) signal by a non-linear device to produce a signal at a lower, intermediate frequency (IF). The non-linear device performing the "mixing" operation is known as a mixer or frequency converter and a typical super-heterodyne transceiver may have more than one mixing stage and thus more than one intermediate frequency. Since the IF signal is at a lower frequency than the RF signal, it can be economically and more efficiently processed in order to extract the desired information.

A well-known problem of the mixing process in super-heterodyne receivers is the generation of image signals in the IF signal. Contrary to mixing in a "complex" mixer, when two signals are mixed using a "real" mixer, signal components are produced at the sum and difference frequencies of the two input signals, and their harmonics. A corollary of this is that, since a "real" mixer does not preserve the polarity of the difference between the input frequencies fed at the mixer inputs, the bands symmetrically located above and below the LO frequency $f_{LO}$ are translated to the same IF frequency.

This mapping of the frequency band of interest or desired band at $f_{LO}+f_{RF}$ along with the image band at $f_{LO}-f_{RF}$ (or vice versa) onto the IF signal causes a significant problem, because after the two RF bands are mapped onto the same IF band, they are no longer distinguishable from each other. Furthermore, any noise or interferers contained in the image band will also be translated to the IF band. This in turn will degrade the signal-to-noise ratio (SNR), and thus reduce the likelihood that all the desired information from the received RF signal can be reliably extracted.

One approach to addressing the image problem involves placing an image rejection filter (also called image reject) in front of the mixer to attenuate signals occurring in the image band of frequencies before carrying out the mixing operation. The double conversion superheterodyne receiver disclosed in GB 2 350 953 A employs such a filter to attenuate image frequency components of the received signal. Unfortunately, this approach suffers from the requirement of a customized design for each desired frequency of operation. Furthermore, it is often difficult to achieve sufficient attenuation across the entire image band using such on-chip filters.

Another approach employs the use of external surface acoustic wave (SAW) filters as bandpass filters to remove energy within the image band prior to frequency conversion. In addition to disadvantages in terms of cost and form factor as well as difficulty integrating, the use of external bandpass filters imposes a severe power penalty due to the need to output match the low-noise amplifier (LNA) and input match the mixer to the 50-Ohm impedance of the filter. Furthermore, such an external filter still may not deliver adequate attenuation across the entire image band.

A third approach involves the use of tuned amplifiers, instead of filters, before the mixer. Unfortunately, it has been difficult to achieve consistent gain and image rejection over a wide range in a tuned amplifier. In addition, slight variations in component characteristics between amplifiers disposed in separate paths in the mixer impede the ability of the amplifiers to track each other with sufficient accuracy for many demanding applications.

Accordingly, there is a need in the art for an improved, yet inexpensive apparatus and/or method for rejecting the image band in radio frequency receivers over a wide frequency range.

## SUMMARY OF INVENTION

In accordance with the present invention in one aspect, there is provided an apparatus for rejecting an image band of frequencies in an radio frequency (RF) signal, the apparatus comprising: an image rejection filter; a local oscillator configured to generate a local oscillator signal; a mixer coupled to the image rejection filter and the local oscillator, the mixer configured to convert a received input signal to a first intermediate frequency (IF) signal based on the local oscillator signal; a frequency divider configured to generate a plurality of local oscillator signals in quadrature with each other; and a translational filter comprising a plurality of passive mixers configured to convert the first IF signal to a plurality of second intermediate frequency (IF) signals in quadrature with each other based on the plurality of quadrature local oscillator signals; and a plurality of frequency-dependent impedances each coupled as a load to an output of a respective one of the plurality of passive mixers, wherein: the image rejection filter and the translational filter combine to provide a bandpass filter for selecting a desired signal in the RF signal and a band-stop filter for suppressing the image band of frequencies in the RF signal.

Optionally, a frequency response of the image rejection filter may include a suppression band of frequencies comprising a first bandwidth. In other words, the image rejection filter may suppress frequencies in the image band according to a first bandwidth. In such optional arrangements a frequency response of the band-stop filter includes a suppression band comprising a second bandwidth, the second bandwidth being greater than the first bandwidth. In other words, the band-stop filter suppresses frequencies in the image band according to a second bandwidth, the second bandwidth being greater than the first bandwidth.

In some exemplary arrangements, the mixer coupled to the image rejection filter may be a balanced mixer and the received input signal at the mixer may be the RF signal. In such exemplary arrangements, the image rejection filter may be comprised within the balanced mixer.

Each of the plurality of frequency-dependent impedances coupled as a load to an output of a respective one of the plurality of passive mixers may comprise a capacitor.

In exemplary arrangements, the plurality of local oscillator signals in quadrature with each other, i.e. the plurality of quadrature local oscillator signals, are derived from the local oscillator signal by means of frequency division.

In other arrangements, the local oscillator is a first local oscillator configured to generate a first local oscillator signal and there is provided a second local oscillator configured to generate a second local oscillator signal, wherein the second local oscillator is coupled to the frequency divider and the plurality of quadrature local oscillator signals are derived from the second local oscillator signal by means of frequency division.

Optionally the apparatus may further comprise a low-noise amplifier operably coupled to receive the RF signal and configured to amplify the RF signal.

According to the invention in a further aspect, there is provided a super-heterodyne receiver comprising an apparatus according to any set out above.

Also in accordance with the present invention, there is provided a method for rejecting an image band of frequencies in a radio frequency (RF) signal, the method comprising the steps: receiving the RF signal; filtering, by an image rejection filter, the RF signal; generating, by a local oscillator, a local oscillator signal; converting, by a mixer, a received signal to a first intermediate frequency (IF) signal based on the local oscillator signal; generating, by a frequency divider, a plurality of local oscillator signals in quadrature with each other; and converting, by a translational filter comprising a plurality of passive mixers and a plurality of frequency-dependent impedances each coupled as a load to an output of a respective one of the plurality of passive mixers, the first IF signal to a plurality of second intermediate frequency (IF) signals in quadrature with each other based on the plurality of quadrature local oscillator signals, wherein: the step of filtering the RF signal and the step of converting the first IF signal to a plurality of quadrature second IF signals provide a bandpass filter for selecting a desired signal in the RF signal and a band stop filter for suppressing the image band of frequencies in the RF signal.

Optionally, the step of filtering the RF signal by the image rejection filter may further comprise suppressing the image band of frequencies according to a first bandwidth. In such cases, the band-stop filter provided by the image rejection filter and the translational filter suppresses the image band of frequencies according to a second bandwidth, the second bandwidth being greater than the first bandwidth.

According to some embodiments, the received signal may be the RF signal. In other embodiments, the received signal may be derived from an output of the image rejection filter and the RF signal may be fed as an input to the image rejection filter.

The method may further comprise the step of amplifying, by a low-noise amplifier, the received RF signal before carrying out the step of filtering the RF signal.

BRIEF DESCRIPTION OF DRAWINGS

**FIG. 1** is a schematic diagram illustrating an exemplary embodiment of an apparatus implemented as part of a super-heterodyne radio receiver according to some embodiments of the present invention.

**FIG. 2** is a schematic diagram illustrating another embodiment of an apparatus implemented as part of a super-heterodyne radio receiver, consistent with other embodiments of the present invention.

**FIG. 3** is a circuit diagram illustrating part of an exemplary apparatus implemented as part of a super-heterodyne radio receiver, consistent with some embodiments of the present invention.

**FIG. 4** is a schematic diagram illustrating an implementation of a translational filter consistent with some embodiments of the present invention.

**FIGS. 5(a)-(d)** illustrate several different embodiments of a frequency-dependent impedance consistent with the present invention.

**FIG. 6** is a pictorial illustration showing the selectivity of an apparatus implemented as part of a super-heterodyne radio receiver, both with and without the presence of the translational filter, consistent with some embodiments of the present invention.

**FIG. 7** is a graphical representation of simulation results illustrating effects of an image rejection filter observed at an output of a first mixer, in response to input frequencies around the image band and the desired band, both with and without the presence of the translational filter, consistent with some embodiments of the present invention.

**FIG. 8** is a flow chart illustrating an exemplary process for receiving and processing an RF signal, consistent with the disclosed invention.

## DESCRIPTION OF EMBODIMENTS

References will now be made in detail to exemplary embodiments, examples of which are illustrated in the accompanying drawings. The following description refers to the accompanying drawings in which the similar numbers in different drawings represent the same or similar elements unless otherwise specified. The implementations set forth in the following disclosure are consistent with aspects related to the invention as recited in the appended claims.

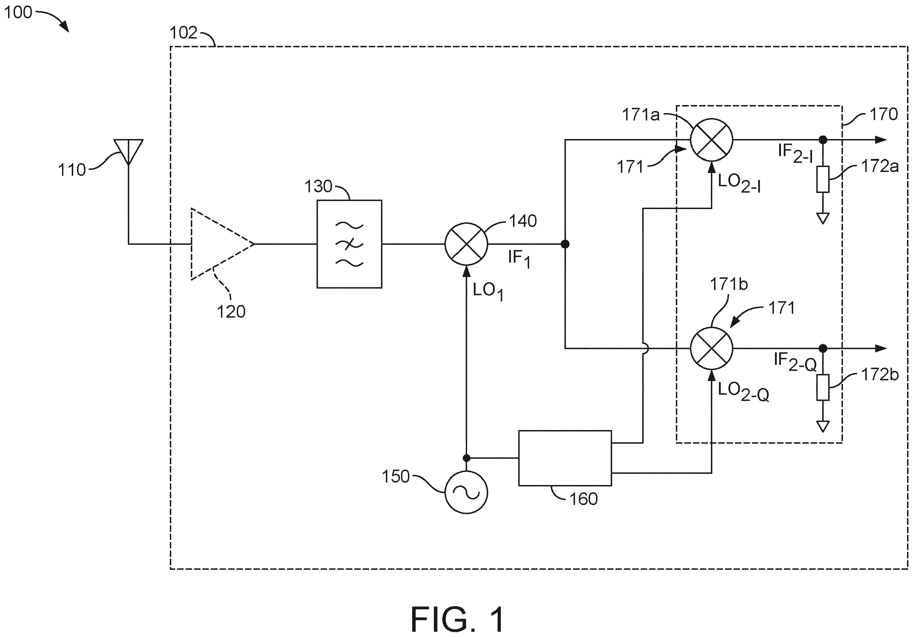

**Fig. 1** illustrates an embodiment of an apparatus 102, implemented within a super-heterodyne radio receiver 100, coupled to an antenna 110. The apparatus 102 optionally comprises a low-noise amplifier (LNA) 120, an image rejection filter 130, a mixer 140, a local oscillator 150, a frequency divider 160, and a translational filter 170.

The antenna 110 may include one or more conductors, electrically coupled to the apparatus 102. The antenna 110 is configured to receive an oscillating electromagnetic field of an incoming radio wave which carries a radio frequency (RF) signal at an RF frequency ($f_{RF}$).

The low-noise amplifier (LNA) 120, if it is present, is coupled to receive the RF signal from the antenna 110 and amplifies the RF signal. The LNA 120 functions to increase the sensitivity of the receiver 100 by amplifying the RF signal while at the same time minimizing the addition of extra noise.

The image rejection filter 130 is coupled to receive the amplified RF signal. In the present embodiment, the image rejection filter 130 is a discrete circuit element (i.e., off-chip) external to the other component of the apparatus 102. However, without limitation, the image rejection filter 130 may alternatively be implemented on-chip. For example, the image rejection filter 130 may be provided as an integrated element of the mixer 140. Alternatively, the image rejection filter 130 may be provided as an integrated element of the low-noise amplifier (LNA) 120, if the latter is present. The image rejection filter 130 may be implemented as a notch filter. For example, the notch filter may be an RF-tunable notch filter that rejects frequencies of the amplified RF signal in the image band by presenting a frequency selective short circuit in the image band, allowing signals in a passband, i.e., a non-rejected frequency band, to be mixed at the mixer 140. Accordingly, the image rejection filter produces a filtered RF signal.

The mixer 140 is a "real" mixer coupled to receive the filtered RF signal at one of the mixer inputs in the present embodiment. A real mixer, in contrast to a complex mixer, does not distinguish between signals located at an equal frequency above and below a local oscillator (LO) frequency, referred to herein as a mixing frequency. The mixer 140 frequency translates the filtered RF signal to another frequency. More particularly, the mixer 140 mixes the filtered RF signal with a signal ($LO_1$) produced by the local oscillator 150, at a LO frequency ($f_{LO1}$). The mixer 140 produces an intermediate frequency signal having an intermediate frequency ($f_{IF1}$). This architecture is referred herein to as a "sliding IF" receiver. This configuration ties the intermediate frequency ($f_{IF1}$) of the intermediate frequency signal $IF_1$ to the RF frequency ($f_{RF}$), such that the intermediate frequency $f_{IF1}$ "slides" with any changes in the RF frequency ($f_{RF}$).

The frequency divider 160 is coupled to receive as input, the local oscillator signal ($LO_1$) at the LO frequency ($f_{LO1}$) produced by the local oscillator 150 and configured to produce a plurality of local oscillator signals ($LO_{2-I}$, $LO_{2-Q}$) in quadrature with each other, each at a second LO frequency ($f_{LO2}$). In the present embodiment, the plurality of quadrature local oscillator signals consist of an in-phase LO signal ($LO_{2-I}$) and a quadrature phase LO signal ($LO_{2-Q}$), each occurring at the same second LO frequency ($f_{LO2}$). "In-phase" and "quadrature phase" refer to two sinusoidal signals that have the same frequency and amplitude but are 90 degrees out of phase, i.e. the signals are orthogonal.

The translational filter 170, which is also known in the art as a "frequency translation filter" or a "transferred impedance filter", includes a quadrature mixer 171. The quadrature mixer is also known in the art as a "complex" mixer since the two LO signals ($LO_{2-I}$, $LO_{2-Q}$) provided to the mixers are orthogonal to each other. In the present embodiment, the quadrature mixer 171 includes passive mixers 171a and 171b, each respectively coupled to a first terminal of frequency-dependent impedance 172a and 172b. The second terminal of frequency-dependent impedances 172a and 172b are coupled to a reference potential or voltage, such as ground. The passive mixers 171a and 171b are each coupled to receive as inputs the intermediate frequency signal ($IF_1$) produced by the mixer 140 and a different one of the plurality of second LO signals ($LO_{2-I}$, $LO_{2-Q}$). In the present embodiment, the second LO signals consist of an in-phase LO signal ($LO_{2-I}$) and a quadrature-phase LO signal ($LO_{2-Q}$). The passive mixer 171a is coupled to receive the in-phase second signal ($LO_{2-I}$) and the passive mixer 171b is coupled to receive the quadrature-phase second signal ($LO_{2-Q}$). Thus the quadrature mixer 171 mixes the intermediate frequency signal ($IF_1$) with the in-phase and quadrature phase LO signals ($LO_{2-I}$, $LO_{2-Q}$) to produce in-phase and quadrature-phase second intermediate frequency signals $IF_{2-I}$ and $IF_{2-Q}$, respectively, at a lower frequency ($f_{IF2}$).

While **Fig. 1** illustrates that the antenna 110 is distinct from the apparatus 102, it should now be appreciated that the antenna 110 may also be implemented as a part of the apparatus 102.

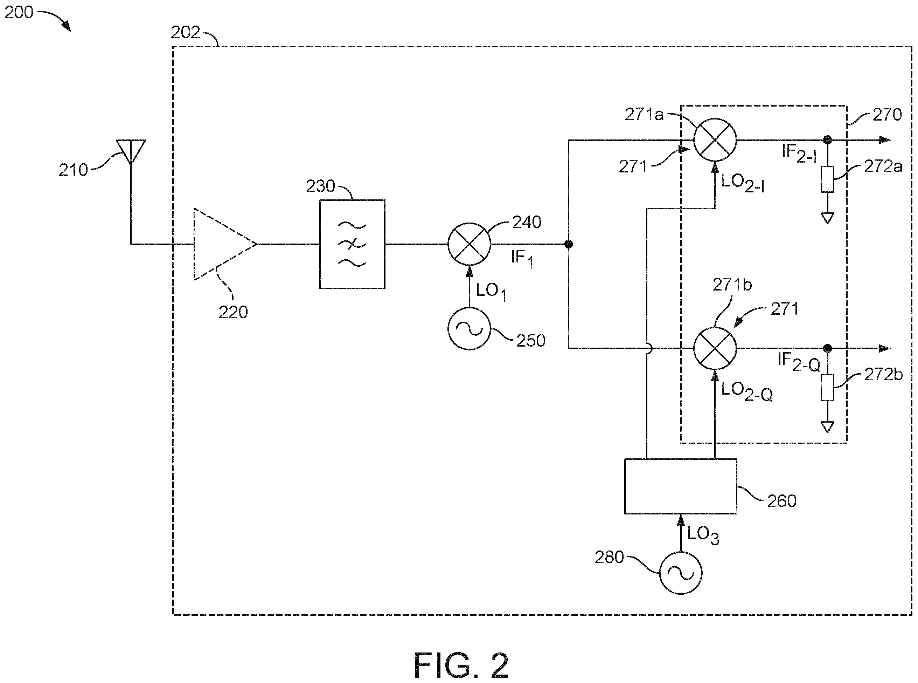

**Fig. 2** illustrates a second embodiment of an apparatus 202 implemented within a super-heterodyne radio receiver 200 having an antenna 210 and optionally a low-noise amplifier (LNA) 220. The apparatus 202 comprises an image rejection filter 230, a mixer 240, a first local oscillator 250, a second local oscillator 280, a frequency divider 260, and a translational filter 270.

The apparatus 202 is identical to the receiver apparatus 102 illustrated in Fig. 1, with the exception of the second local oscillator 280 that produces a third LO signal ($LO_3$) which feeds into the frequency divider 260 to generate the plurality of local oscillator signals in quadrature with each other. The frequency divider 260 is coupled to receive as input, the third LO signal ($LO_3$) generated by the second local oscillator 280 at a third frequency ($f_{LO3}$) and configured to produce a plurality of quadrature local oscillator signals ($LO_{2-I}$, $LO_{2-Q}$) each at a second frequency ($f_{LO2}$). In the present embodiment, the plurality of second signals comprise an in-phase LO signal ($LO_{2-I}$) and a quadrature phase LO signal ($LO_{2-Q}$) each having the same amplitude and occurring at the second frequency ($f_{LO2}$). In one aspect of the present embodiment, the in-phase and the quadrature-phase LO signals are 90 degrees phase shifted from each other.

A down-conversion operation for the super-heterodyne receiver is described next with reference to **Fig. 1.**

A down-conversion path of the RF signal starts with reception of the RF signal by the antenna 110. The received RF signal may contain various frequency components, including frequencies outside of a desired RF frequency band. The desired band contains information that is assumed to be useful and centered around a carrier frequency of the RF signal. The other frequency bands may contain noise and interference signals that would interfere with the extraction of information from the desired band. Optionally, the low-noise amplifier (LNA) 120 amplifies the received RF signal, preferably introducing as little additional noise as practical into the received RF signal. After amplification by the LNA 120, the amplified RF signal is filtered by the image rejection filter 130. The operation of the image rejection filter 130 is described in further detail below.

The filtered RF signal is then fed to the mixer 140, where it is mixed with the oscillator signal ($LO_1$) produced by the local oscillator 150. The mixer 140 is configured to produce both sum and difference beat frequency signals. The mixer 140, for example, produces the first intermediate frequency signal ($IF_1$) having the intermediate frequency ($f_{IF1}$), by mixing the local oscillator signal ($LO_1$) with the filtered RF signal. Aspects of the mixing process are well known by the skilled person.

The first intermediate frequency signal ($IF_1$) having the intermediate frequency ($f_{IF1}$) may be further down-converted by a quadrature mixer 171 of the translational filter 170 to produce the plurality of second intermediate frequency signals ($IF_{2-I}$ and $IF_{2-Q}$) in quadrature with each other at a second intermediate frequency ($f_{IF2}$). The first intermediate frequency signal $IF_1$ is fed to each of passive mixers 171a and 171b at their respective inputs. The plurality of second oscillator signals ($LO_2$), including the in-phase LO signal ($LO_{2-I}$) and the quadrature-phase LO signal ($LO_{2-Q}$), are fed to the respective passive mixers 171a and 171b. The passive mixers 171a and 171b are configured to mix the first intermediate signal ($IF_1$) with LO signals $LO_{2-I}$ and $LO_{2-Q}$, respectively, to produce the plurality of second intermediate frequency signals in quadrature with each other $IF_{2-I}$ and $IF_{2-Q}$, respectively. Each of the second oscillator signals ($LO_2$) are at the second LO frequency ($f_{LO2}$), and the second intermediate frequency signals ($IF_{2-I}$ and $IF_{2-Q}$) are at the second intermediate frequency ($f_{IF2}$). The relation between $f_{IF1}$ and $f_{IF2}$ is given by:

$$f_{IF_2} = f_{IF_1} - f_{LO_2} \qquad (1)$$

After output by the translational filter 170, second intermediate frequency signals $IF_{2-I}$ and $IF_{2-Q}$ may be summed for additional demodulation and detection to extract the useful information contained within, or may be subject to a further mixing process not illustrated herein.

In the "sliding IF" super-heterodyne receiver illustrated in **Fig. 1,** in one exemplary implementation, the frequency divider 160 is configured as a "divide-by-2" frequency divider, and the plurality of quadrature oscillator signals ($LO_{2-I}$, $LO_{2-Q}$) at the second frequency ($f_{LO2}$) are directly derived from the local oscillator signal ($LO_1$) at the first LO frequency ($f_{LO1}$) via the "divide-by-2" frequency divider 160. The frequency divider 160 generates in-phase and quadrature phase LO signals ($LO_{2-I}$, $LO_{2-Q}$) that effect the second or final frequency down-conversion to base band.

Providing the first LO frequency ($f_{LO1}$) at twice the value of the second LO frequency ($f_{LO2}$) results in the following frequency relationships for the first down-conversion.

$$f_{LO_1} = 2 \cdot f_{RF}/3 \quad \text{and} \quad f_{IF_1} = f_{RF}/3 \qquad (2a)$$

Alternatively, the frequency divider 160 may divide the first LO frequency ($f_{LO1}$) by a factor of four via a "divide-by-four" frequency divider 160, which results in the following frequency relationship.

$$f_{LO_1} = 4 \cdot f_{RF}/5 \quad \text{and} \quad f_{IF_1} = f_{RF}/5 \qquad (2b)$$

Since it is generally more difficult to design circuits for high frequency, as previously described, it may be desirable to design for operation with a relatively lower IF frequency. On the other hand, by choosing a relatively lower IF frequency, the frequency separation between the image band and the desired band decreases, so that suppression of signals in the image band provided by the image rejection filter 130 or 230 becomes less effective as the division factor of the frequency divider 160 increases. It would be desirable to maintain the suppression of the image band at an acceptable level while operating with a relatively high division factor of the frequency divider 160 to obtain a lower IF frequency.

A person skilled in the art will now appreciate that the principle of operation for the "sliding IF" receiver would be similar to the more general example of the super-heterodyne receiver 200 illustrated in **Fig. 2.**

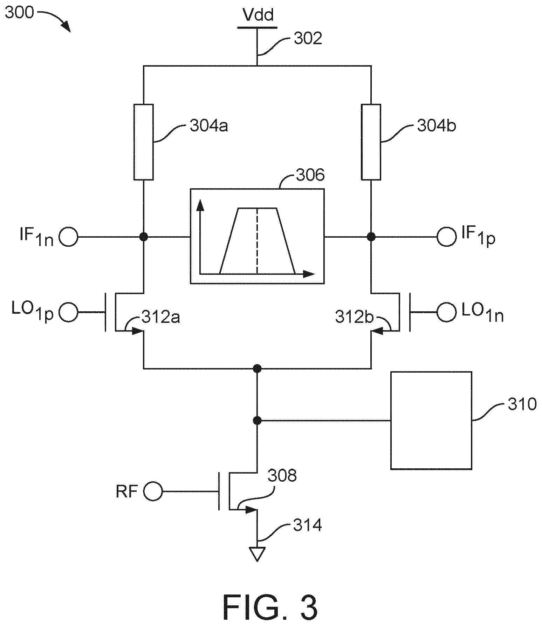

**Fig. 3** illustrates an RF integrated CMOS circuit 300, which is an implementation of the apparatus 102 or 202 illustrated in **Fig. 1** and **Fig. 2,** respectively. For clarity, **Fig. 3** omits other components such as an antenna, local oscillators, a frequency divider, and a low-noise amplifier (LNA). However, it will now be appreciated by a skilled person in the art that **Fig. 3** only illustrates one possible implementation of the apparatus 102 or 202, and that the apparatus 102 or 202 having a translational filter as disclosed herein can be implemented in other configurations and with different circuitry.

The RF integrated CMOS circuit 300 is configured for connection to a power supply voltage Vdd 302, and includes a pair of load impedances 304a and 304b, a translational filter 306, a tail transistor 308, an image rejection filter 310, and a pair of transistors 312a and 312b, otherwise referred to as a differential pair. The power supply voltage Vdd 302, the load impedances 304a and 304b, the differential transistor pair 312a and 312b, and the tail transistor 308 for receiving an input signal together form a real, active, single-balanced mixer, which is a non-limiting embodiment of the first mixer 140 or 240. In **Fig. 3,** the power supply voltage Vdd 302 is coupled to a first terminal of the load impedances 304a and 304b, a second terminal of which are coupled to the drain terminals of the transistors 312a and 312b, respectively. The translational filter 306, which corresponds to the translational filter 170 or 270, is coupled between the drain terminals of the transistors 312a and 312b. A local oscillator not illustrated in **Fig. 3,** provides a positive first signal ($LO_{1p}$) and a negative first signal ($LO_{1n}$) at the gates of the transistors 312a and 312b, respectively. The skilled person will understand that this implementation requires a differential local oscillator signal and will know how this may be generated. The transistors 312a and 312b output a positive intermediate frequency signal ($IF_{1n}$) and a negative intermediate frequency signal ($IF_{1p}$) at their respective drain terminals, i.e. a differential output. The source terminals of the transistors 312a and 312b are coupled to each other, which is in turn coupled to the drain terminal of the tail transistor 308. The image rejection filter 310 is coupled to the RF integrated CMOS circuit 300 at a node connecting the drain terminal of the tail transistor 308 with the source terminals of the transistors 312a and 312b. The source terminal of the tail transistor 308 may be coupled to a reference potential or voltage, such as a ground 314. If provided as part of a super-heterodyne receiver, an antenna structure and/or a low-noise amplifier (LNA), not shown in **Fig. 3,** may receive and amplify the RF signal, and couple the amplified signal to the gate of the tail transistor 308 as the received input signal. In this case, the gate of tail transistor 308 receives the RF signal as the received input signal.

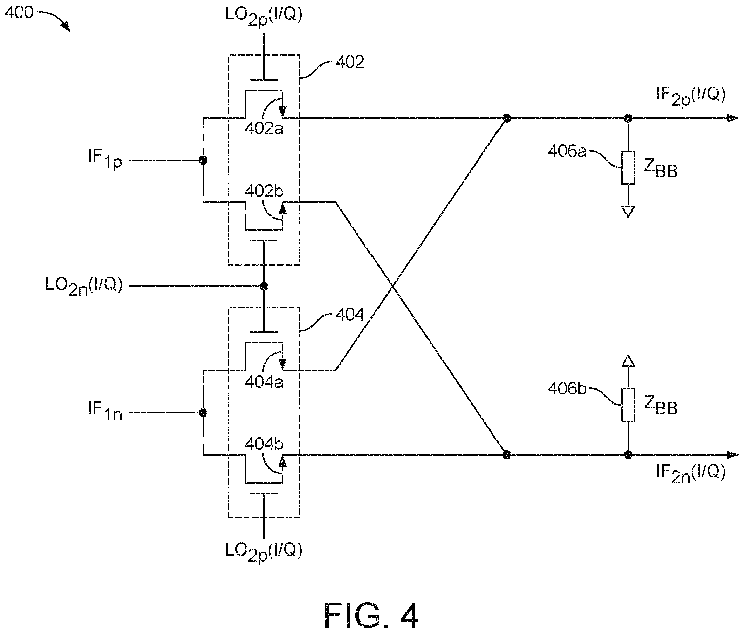

**Fig. 4** illustrates an exemplary differential implementation of the translational filter 400. For simplicity, only one-half, e.g., in-phase path, of the translational filter is shown. The other side, e.g., quadrature phase path, may be implemented in the same manner. The translational filter 400 includes transistor pairs 402 and 404 configured as a differential passive mixer which may correspond to one of the passive mixers 171a and 171b or 271a and 271b. The translational filter 400 further includes impedances 406a and 406b, one terminal of which is coupled to the outputs of the transistor pairs 402 and 404. The other terminal of each of the impedances 406a and 406b is coupled to a reference potential or voltage, such as ground. In contrast to an "active" mixer disclosed in **Fig. 3,** the passive mixer in the translational filter 400 does not require Vdd to provide power for the mixing process. The transistor pair 402 comprises transistors 402a and 402b, and the transistor pair 404 comprises transistors 404a and 404b. In this non-limiting example, the transistors are provided as MOSFET transistors. In some embodiments, a common terminal of transistors 402a and 402b may be coupled to the drain terminal of the transistor 312a in **Fig. 3,** and a common terminal of transistors 404a and 404b maybe coupled to the drain terminal of the transistor 312b in **Fig. 3.**

The transistors 402a and 402b are coupled to receive as input at their drain terminals, the positive intermediate frequency signal ($IF_{1p}$). The transistors 404a and 404b are coupled to receive as input at their drain terminals, the negative intermediate frequency signal ($IF_{1n}$). The transistors 402a and 404b are coupled to receive a positive second signal ($LO_{2p-(I/Q)}$) at their respective gates, while the transistors 402b and 404a are coupled to receive a negative second signal ($LO_{2n-(I/Q)}$) at their corresponding gates. The sources of the positive and negative second signals $LO_{2p-(I/Q)}$ and $LO_{2n-(I/Q)}$ are omitted from **Fig. 4,** but a skilled person will now appreciate that the positive and negative second signals $LO_{2p-(I/Q)}$ and $LO_{2n-(I/Q)}$ may be produced, for example, by the local oscillator 180, or the frequency divider 160 or 260. Moreover, the positive and negative second signals $LO_{2p}$ and $LO_{2n}$ may be either in-phase signals or quadrature signals. The transistors 402a and 404a are coupled to produce a positive second intermediate frequency signal ($IF_{2p-(I/Q)}$) at their source terminals, and the transistors 402b and 404b are coupled to produce a negative second intermediate frequency signal ($IF_{2n-(I/Q)}$) at their respective source terminals. Since the transistors shown in **Fig. 4** essentially operate as switches, the skilled person will appreciate that the drain and source terminals of the transistors 402a and 402b and the transistors 404a and 404b can be interchanged without affecting the operation of the circuit.

A skilled person will now appreciate that although only one passive mixer is illustrated in **Fig. 4,** the quadrature mixer 171 or 271 comprises two such passive mixers. For example, the elements and the arrangement of elements of the passive mixers 217a and 271b are substantially similar. Moreover, a skilled person will now appreciate that the positive second intermediate frequency signal ($IF_{2p-(I/Q)}$) and the negative second intermediate frequency signal ($IF_{2n-(I/Q)}$) are either in-phase signals or quadrature-phase signals, depending whether the translational filter 400 is coupled to receive the in-phase second signals ($LO_{2p/n-I}$) or the quadrature-phase second signals ($LO2_{p/n-Q}$). Moreover, a skilled person will also now appreciate that the passive mixer 400 may be configured such that the switch pairs 402 and 404 receive the positive intermediate frequency signal ($IF_{1p}$) and the negative intermediate frequency signal ($IF_{1n}$) at their respective source terminals and produce the positive second intermediate frequency signal ($IF_{2p-(I/Q)}$) and the negative second intermediate frequency signal ($IF_{2n-(I/Q)}$) at their respective drain terminals.

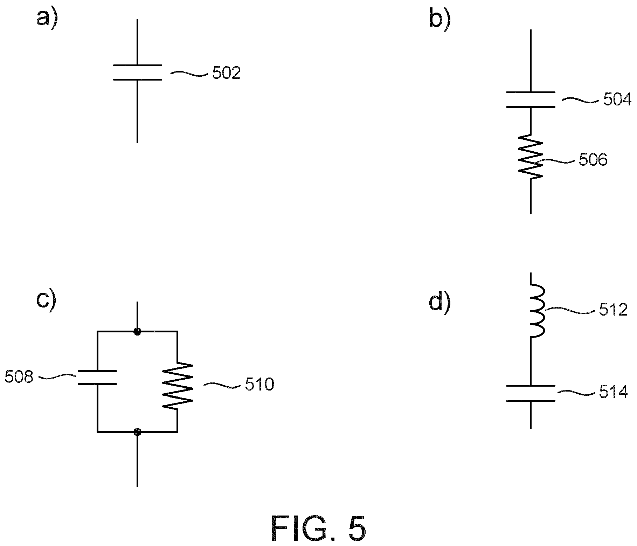

**Figs. 5(a)-(d)** illustrate several different embodiments of a frequency-dependent impedance consistent with the present invention. As described herein, a frequency-dependent impedance is coupled as a load to the output of each passive mixer 171a, 171b, 271a, 271b comprised in the translational filter 170, 270. The skilled person will understand the term "as a load" to mean that the frequency-dependent impedance is coupled between the output terminal of a respective passive mixer and a ground connection.

In one embodiment, each of the plurality of frequency-dependent impedances 172a, 172b, 272a, 272b may be a capacitor 502 as shown in Fig. 5(a). In another embodiment, each of the plurality of frequency-dependent impedances 172a, 172b, 272a, 272b may be a capacitor 504 connected in series with a resistor 506 as illustrated in Fig. 5(b). Alternatively, each of the plurality of frequency-dependent impedances 172a, 172b, 272a, 272b may be configured as a capacitor 508 in parallel with a shunt resistor 510 as shown in Fig. 5(c). According to another embodiment, each of the plurality of frequency-dependent impedances 172a, 172b, 272a, 272b may be an inductor 512 connected in series with a capacitor 514 as shown in Fig. 5(d).

Aspects of the image rejection characteristic of apparatus 102 or 202 will be now described.

One aspect of a real mixer is that during the down-conversion process, the mixer may down convert frequency components of the RF signal from bands outside the desired RF band into the intermediate frequency signal. In particular, a real frequency mixer may be susceptible to convert such signals when signals in the image band are present, where the image frequency ($f_{IM}$) is given by the relations (3) and (4):

$$f_{IF_1} = f_{LO_1} - f_{IM} \quad (3)$$

Substituting for terms from equations (2a), for operation of the "sliding IF" receiver illustrated in **Fig. 1,** the expression for the image frequency ($f_{IM}$) is given as:

$$f_{IM} = f_{RF}/3 \qquad (4)$$

As noted above, the desired band includes a desired signal containing useful information modulated onto the RF signal that is to be received and processed. However, the signal in the desired band may have a low amplitude. The image band typically contains noise and may also include a blocker or interference signal at a significantly higher amplitude than the desired signal in the desired band. Any signal (i.e., noise and interference signal) that exists around the image frequency ($f_{IM}$) may be mixed by the mixer 140 and down-converted into $IF_1$ along with the desired signal in the desired band. However, the image band and, consequently, signals appearing in the image band may be rejected prior to translational at the mixer 140. The level of image rejection is determined by the selectivity of the image rejection filter 130, with the desired signal in the desired band only experiencing minimum attenuation by the image rejection filter 130. The filtered RF signal is fed to the mixer 140, which in turn down-converts equally any remaining signal in both the image band and the desired band, to produce the intermediate frequency signal ($IF_1$).

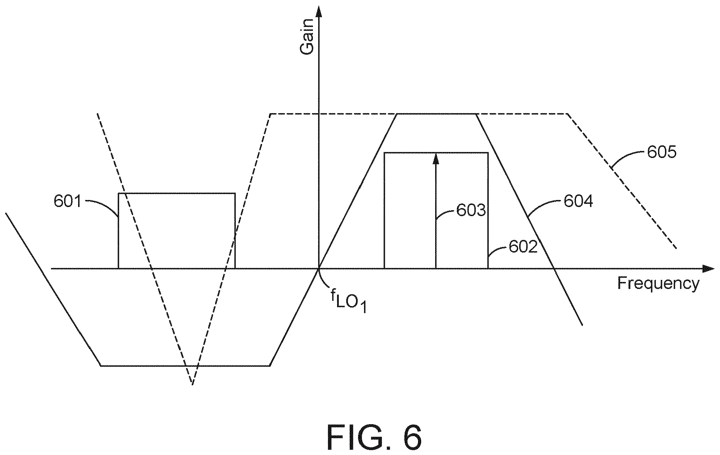

Preferably, the image rejection filter 130, implemented as a notch filter, rejects all of the image band. However, due to design considerations and ease of IC integration, it may not be possible to design an image rejection filter with sufficient suppression in the image band. All notch filters have a finite image response, meaning noise and interference signals existing at the frequencies near the edge of or inside the image band may not be filtered sufficiently, such that these signals may partially corrupt the intermediate frequency signal ($IF_1$) by their presence, especially if they appear at high signal strength. Therefore, the above disclosed embodiments consistent with the present invention provide improvement to further increase the image rejection response. **Fig. 6** illustrates the limitation of an image rejection filter with a narrow image rejection bandwidth.

**FIG. 6** is a pictorial representation of a frequency response of an image rejection filter such as image rejection filter 130 or 230, implemented as a notch filter, both with and without the presence of a translational filter, such as the translational filter 170 or 270. **Fig. 6** illustrates the image band 601 and the desired band 602 spaced equally from the first frequency ($f_{LO1}$) at the input of the image rejection filter 130 or 230. The horizontal axis is frequency centered at the first frequency ($f_{LO1}$). The vertical axis represents relative signal power. Dashed trace 605 represents the frequency response of the image rejection filter 130 or 230 in a conventional receiver apparatus, i.e., one that does not include a translational filter. For frequencies below the first frequency ($f_{LO1}$) (on the left of the first frequency ($f_{LO1}$)), the image rejection filter 130 or 230 has a finite, narrow width stop-band centered around the image frequency. For frequencies above the first frequency ($f_{LO1}$) (on the right side of first frequency ($f_{LO1}$)), the image rejection filter 130 or 230 has a wide pass-band centered around the desired band. However, the bandwidth of the stop-band may be too narrow to adequately reject the entire image band, such that noise and interference signals at the edge of the image band may be mixed by the first mixer 140 or 240 into or close to the intermediate frequency signal ($IF_1$) band.

In view of these limitations of the image rejection filter 130 or 230, embodiments described herein improve overall image rejection by implementation of the translational filter 170 or 270 in receiver apparatus 102 or 202, respectively. For example, when the translational filter 170 or 270 is coupled to the output of the first mixer 140 or 240 in the receiver apparatus 102 or 202, the translational filter 170 or 270 has a desirable effect on the desired and image frequency response of the receiver apparatus 102 or 202. Solid trace 604 represents a composite frequency response of the image rejection filter 130 or 230 and the translational filter 170 or 270, respectively, consistent with embodiments of the present invention.

In **Fig. 6,** solid trace 604 illustrates that the addition of the translational filter 170 or 270 narrows the bandwidth of the pass-band around the "desired band" 602. Moreover, the translational filter 170 or 270 also provides a wider bandwidth of the stop-band around the image band 601 at the same time as the bandwidth of the pass-band around desired signal band 602 is narrowed, as illustrated by the solid trace 604. The impact of noise and interference signals close to the desired RF signal 603 at the carrier frequency ($f_{RF}$) and the impact of noise and interference signals over a wide frequency range near an image frequency ($f_{IM}$) at the center of the image band 601 can be significantly minimized at the same time. Narrowing of the band-pass response around the desired band while widening the band-stop response around the image band also improves the receiver selectivity, allowing the receiver apparatus 102 or 202 to be more tolerant of interference that may occur across the RF spectrum.

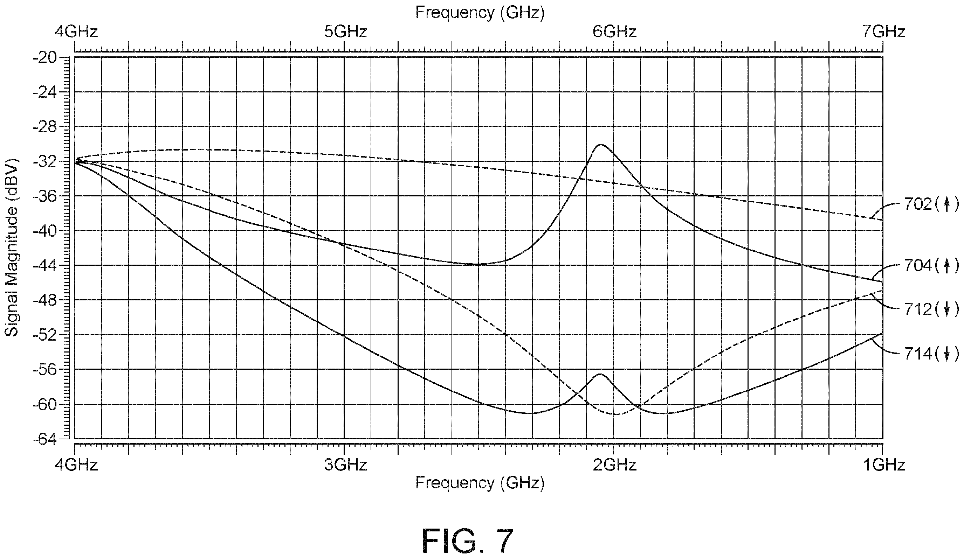

**FIG. 7** is a graphical representation of simulation results illustrating filtering characteristics at the output of the first mixer 140 or 240, in response to input frequencies around the image band and the desired band. Dashed curves 702 and 712 illustrate the response to frequencies in the desired band and the image band, respectively, resulting from only the image rejection filter 130 or 230. Solid curves 704 and 714 illustrate the response to frequencies in the desired band and the image band according to exemplary embodiments of the present invention.

The simulations plotted in **Fig. 7** were performed at the transistor level of the "sliding IF" receiver illustrated in **Fig. 1.** Simulations were performed using the simulation tool Cadence Spectre RF™. The parameters for the simulation assumed a typical notch filter designed to have a "notch" at 2 GHz and therefore reject frequencies around 2 GHz, the input RF signal was at 6 GHz, an intermediate frequency ($f_{IF1}$) was centered at 2 GHz, first frequency ($f_{LO1}$) was 4 GHz, and the corresponding image frequency ($f_{IM}$) was 2 GHz. The horizontal axis refers to an absolute frequency range that corresponds to the RF range of frequencies (4 GHz-7 GHz (above $f_{LO1}$) for curves 702 and 704 in the desired band, labeled on the top of the graph; 4 GHz-1 GHz (below $f_{LO1}$) for curves 712 and 714 in the image band, labeled on the bottom of the graph), and the vertical axis is signal level at the first mixer output expressed in decibels relative to 1 volt (dBV). A skilled person will now appreciate that the parameters given in the simulation are mere examples to illustrate effects of the disclosed embodiments, and is not the only implementation of the embodiments consistent with the present invention.

Curve 702 represents the frequency response around the RF center frequency ($f_{RF}$) in the desired band. As seen in curve 702, with only the image rejection filter 130 or 230, the receiver apparatus 202 has a wide bandwidth of the pass-band around the center RF frequency ($f_{RF}$) of 6 GHz. The simulation confirms that the level of signals in the desired band (shown with reference to top horizontal axis from 4 GHz to 7 GHz) varies only slightly, meaning that there is little selectivity of signals in the desired band. Curve 712 represents the frequency response of the image rejection filter around the image frequency (shown with bottom horizontal axis from 4 GHz to 1 GHz), including a bandwidth of a stop-band around the center image frequency ($f_{IM}$). Curve 712 confirms that the signal level decreases moving toward the center image frequency ($f_{IM}$) at 2 GHz, and increases moving away from the center image frequency ($f_{IM}$), as expected for a notch filter.

An image rejection ratio can be estimated based on the simulated results. The image rejection ratio is a ratio of a level of presence of the image band signals to the level of presence of the desired band signals. The image rejection ratio can be obtained by determining the difference between the value of signal level of curve 702 at 6 GHz (center of desired band) and the value of signal level of curve 712 at 2 GHz. For example, curve 702 shows that a signal in the RF band ($f_{RF}$) at 6 GHz generates a signal level of -35 dBV when it is frequency translated to the intermediate frequency ($f_{IF1}$). At the same time, curve 712 shows that a signal from the image band at 2GHz generates a signal level of -61 dBV when it is translated to the intermediate frequency ($f_{IF1}$). In **Fig. 7**, the image rejection ratio is close to 25 dB at frequencies around the center image frequency ($f_{IM}$) of 2 GHz. Moreover, curve 712 shows that the receiver apparatus 102 or 202 with only image rejection filter 130 or 230 provides a 20 dB level of image rejection ratio, over a bandwidth of about 500 MHz centered around the center image frequency ($f_{IM}$).

Curve 704 represents the frequency response of a signal around the desired band at the center RF frequency ($f_{RF}$) according to embodiments of the present invention. As described above, the simulation confirms that with the translational filter 270, the receiver 200 has a narrower bandwidth of the pass-band around the center RF frequency ($f_{RF}$). The simulation illustrates that attenuation for signals (shown with reference to top horizontal axis from 4 GHz to 7 GHz) varies significantly. At 6 GHz, a signal level of -31 dBV is generated, while at 5.6 GHz the signal level is -44 dBV. The additional selectivity at the desired band is desirable to reduce the unwanted impact of close-to-carrier blocker or interferer signals. Curve 714 represents the composite frequency response of the image rejection filter and the translational filter around the image band (shown with reference bottom horizontal axis 4 GHz to 1 GHz), including a bandwidth of a stop-band around the center image frequency ($f_{IM}$). The image rejection ratio is close to 25 dB at the center image frequency ($f_{IM}$) at 2 GHz, which is similar to the case without translational filter 270, despite an apparent "bump" in attenuation of curve 714 at the center image frequency ($f_{IM}$). More importantly, however, curve 714 shows greater image rejection in frequencies farther from the center image frequency ($f_{IM}$) as compared to curve 712. For example, curve 714 has greater than 20 dB image rejection ratio over a bandwidth of 2 GHz, from 1 GHz to 3 GHz. The "bump" represents less attenuation for the signal at the image frequency ($f_{IM}$), which is undesirable. However, this effect is partially compensated because the signal at the center RF frequency ($f_{RF}$) is at a higher amplitude, therefore the image rejection ratio at the band center remains comparable to that of a conventional super-heterodyne receiver despite this effect.

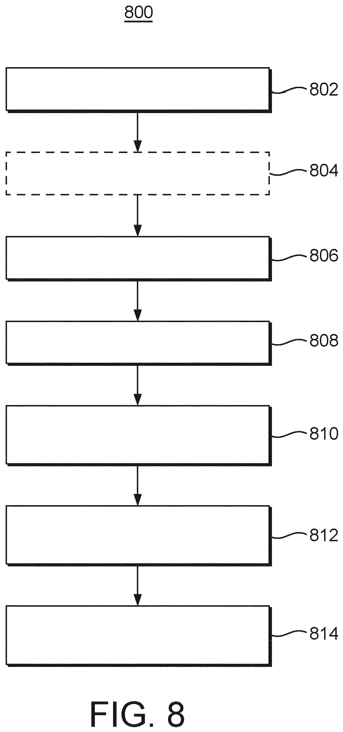

Fig. 8 is a flow chart illustrating an exemplary embodiment of a process 700 for rejecting an image band in an RF signal, using the receiver apparatus 102 or 202.

Process 800 begins with receiving an RF signal in step 802. The receiver apparatus 102 or 202 may receive the RF signal from external sources coupled to the receiver apparatus 102 or 202. In some alternative embodiments, the RF signal may be received by the antenna 110 or 210, and amplified by the low-noise amplifier (LNA) 120 or 220 in an optional step 804. In step 806, the received RF signal is filtered by the image rejection filter 130 or 230, and is then coupled to the mixer 140 or 240. In step 808, the first local oscillator 150 or 250 produces the oscillator signal ($LO_1$) which is fed to the first mixer 140 or 240. In step 810, the first mixer 140 or 240 performs a first stage mixing operation, producing the intermediate frequency signal ($IF_1$) at the intermediate frequency ($f_{IF1}$) from the operation of mixing the local oscillator signal ($LO_1$) with the filtered RF signal. In step 812, the frequency divider 160 or 260 produces a plurality of quadrature local oscillator signals ($LO_{2-I}$, $LO_{2-Q}$). In the exemplary embodiments, the plurality of quadrature oscillator signals comprise the in-phase LO signal ($LO_{2-I}$) and the quadrature phase LO signal ($LO_{2-Q}$), each coupled to the quadrature mixer 171 or 271. In the exemplary embodiment, the passive mixer 171a or 271a is coupled to receive $LO_{2-I}$, and the passive mixer 171b or 271b is coupled to receive $LO_{2-Q}$. The frequency divider 160 or 260 may be coupled to receive the first signal ($LO_1$) as an input, or alternatively, receive LOs as an input, LOs being produced by the second local oscillator 280. In step 814, the translational filter 170 or 270 produces the plurality second intermediate frequency signals ($IF_{2-I}$, $IF_{2-Q}$) at the second intermediate frequency ($f_{IF2}$). In the exemplary embodiment, the passive mixer 171a or 271a produces the in-phase component of the second intermediate frequency signal ($IF_{2-I}$), and the passive mixer 171b or 271b produces the quadrature phase component of the second intermediate frequency signal ($IF_{2-Q}$).

It will be appreciated by a skilled person that **Figs. 1, 2** and **4** only illustrate one possible implementation of the impedances connected to the outputs of quadrature mixers 171 and 271. For example, the impedances, which may be 172a, 172b, 272a or 272b, may each include one or more resistive elements that are connected to one or more capacitive elements or capacitors. In another example, one or more inductive elements may be connected to one or more capacitive elements or capacitors so that the impedances are each an LC circuit. Alternatively, one or more inductive elements and resistive elements may be connected to one or more capacitors to form the impedances so that the impedances are each an RLC circuit.

It will be appreciated that although **Fig. 1** and **Fig. 2** illustrate circuits as single ended circuits, the embodiments may be implemented in differential circuits without departing from the teachings of the present invention.

It will be appreciated by a skilled person that the super-heterodyne receivers 100 and 200 may be implemented in integrated circuit (CMOS, SiGe, GaAs) radio receivers for all wireless applications, including cellular (e.g. LTE®), connectivity (e.g. WLAN) and GNSS (e.g. GPS).

Moreover, while illustrative embodiments have been described herein, the scope includes any and all embodiments having equivalent elements, modifications, omissions, combinations (e.g., of aspects across various embodiments), adaptations and/or alterations based on the present invention. The elements in the claims are to be interpreted broadly based on the language employed in the claims and not limited to examples described in the present specification or during the prosecution of the application, which examples are to be construed as nonexclusive. Further, the steps of the disclosed methods can be modified in any manner, including reordering steps and/or inserting or deleting steps.

The features and advantages of the invention are apparent from the detailed specification. As used herein, the indefinite articles "a" and "an" mean "one or more." Similarly, the use of a plural term does not necessarily denote a plurality unless it is unambiguous in the given context. Words such as "and" or "or" mean "and/or" unless specifically directed otherwise.

Other embodiments will be apparent from a consideration of the specification and practice of the embodiments disclosed herein. It is intended that the specification and examples be considered as an example only, with a true scope of the disclosed embodiments being indicated by the following claims.

Descriptions of the disclosed embodiments are not exhaustive and are not limited to the precise forms or embodiments disclosed. Modifications and adaptations of the embodiments will be apparent from consideration of the specification and practice of the disclosed embodiments. For example, the described implementations include hardware, firmware, and software, but systems and techniques consistent with the disclosure of the present invention may be implemented as hardware alone. Additionally, the disclosed embodiments are not limited to the examples discussed herein.

In this description, the conjunction "and/or" may mean each of the listed items individual, a combination of the listed items, or both. Moreover, the "and/or" conjunction as used in this specification may include all combinations, subcombinations, and permutations of listed items. For example, the phrase "A, B, and/or C" may mean each of A, B, and C individually, as well as A, B, and C together in addition to sub-groups A and B, A and C, and B and C. Unless specified otherwise, this example use of "and/or" may also intend to include all potential orders of items in each group and sub-group, such as B-C-A, B-A-C, C-A-B, C-B-A, and A-C-B, along with the subgroups C-B, B-A, and C-A.

The elements in the claims are to be interpreted broadly based on the language employed in the claims and not limited to examples described in the present specification or during the prosecution of the application, of which examples are to be construed as non-exclusive. Further, the steps of the disclosed methods may be modified in any manner, including by reordering steps or inserting or deleting steps. It is intended, therefore, that the specification and examples be considered as exemplary only, with the scope being indicated by the following claims.

**Claims**

1. An apparatus (102, 202) for rejecting an image band (601) in a radio frequency, RF, signal, the apparatus comprising:

   an image rejection filter (130, 230);
   an oscillator (150, 250) configured to generate an oscillator signal ($LO_1$);
   a mixer (140, 240) coupled to the image rejection filter and the oscillator, the mixer configured to convert a received input signal to a first intermediate frequency signal ($IF_1$) based on the oscillator signal ($LO_1$);
   a frequency divider (160, 260) configured to generate a plurality of oscillator signals in quadrature with each other ($LO_{2-I}$, $LO_{2-Q}$); and
   a translational filter (170, 270) comprising a plurality of passive mixers (171a, 171b, 271a, 271b) configured to convert the first intermediate frequency signal ($IF_1$) to a plurality of second intermediate frequency signals in quadrature with each other ($IF_{2-I}$, $IF_{2-Q}$) based on the plurality of quadrature oscillator signals ($LO_{2-I}$, $LO_{2-Q}$); and a plurality of frequency-dependent impedances (172a, 172b, 272a, 272b) each coupled as a load to an output of a respective one of the plurality of passive mixers, wherein:
   the image rejection filter (130, 230) and the translational filter (170, 270) are adapted to combine to provide a bandpass filter for selecting a desired signal (603) in the RF signal and a band-stop filter for suppressing the image band (601) in the RF signal.

2. The apparatus according to claim 1, wherein a frequency response of the image rejection filter includes a suppression band comprising a first bandwidth.

3. The apparatus according to claim 2, wherein a frequency response of the band-stop filter includes a suppression band comprising a second bandwidth, the second bandwidth being greater than the first bandwidth.

4. The apparatus according to any preceding claim, wherein the mixer coupled to the image rejection filter is a balanced mixer (300) and the received input signal is the RF signal.

5. The apparatus according to claim 4 wherein the image rejection filter (310) is comprised within the balanced mixer (300).

6. The apparatus according to any preceding claim, wherein each of the plurality of frequency-dependent impedances comprises a capacitor.

7. The apparatus according to any preceding claim, wherein the plurality of quadrature oscillator signals ($LO_{2-I}$, $LO_{2-Q}$) are derived from the oscillator signal ($LO_1$) by frequency division.

8. The apparatus of any one of claims 1 to 6, wherein the oscillator is a first oscillator (250) configured to generate a first oscillator signal ($LO_1$) and the apparatus further comprises a second oscillator (280) configured to generate a second oscillator signal ($LO_3$), wherein the second oscillator (280) is coupled to the frequency divider (260) and the plurality of quadrature oscillator signals ($LO_{2-I}$, $LO_{2-Q}$) are derived from the second oscillator signal ($LO_3$) by frequency division.

9. The apparatus according to any preceding claim, wherein the apparatus further comprises a low-noise amplifier (120, 220) operably coupled to receive the RF signal and configured to amplify the RF signal.

10. A super-heterodyne receiver (100, 200) comprising the apparatus according to any preceding claim.

11. A method (800) for rejecting an image band (601) in a radio frequency, RF, signal, the method comprising:

   receiving (802) the RF signal;
   filtering (806), by an image rejection filter, the RF signal;
   generating (808), by an oscillator, an oscillator signal ($LO_1$);
   converting (810), by a mixer, a received signal to a first intermediate frequency signal ($IF_1$) based on the oscillator signal ($LO_1$);
   generating (812), by a frequency divider, a plurality of oscillator signals in quadrature with each other ($LO_{2-I}$, $LO_{2-Q}$); and
   converting (814), by a translational filter comprising a plurality of passive mixers (171a, 171b, 271a, 271b) and a plurality of frequency-dependent impedances (172a, 172b, 272a, 272b) each coupled as a load to an output of a respective one of the plurality of passive mixers, the first intermediate frequency signal ($IF_1$) to a plurality of second intermediate frequency signals in quadrature with each other ($IF_{2-I}$, $IF_{2-Q}$) based on the plurality of quadrature oscillator signals ($LO_{2-I}$, $LO_{2-Q}$), wherein:
   the filtering (806) the RF signal and converting (814) the first intermediate frequency signal ($IF_1$) to a plurality of quadrature second intermediate frequency signals ($IF_{2-I}$, $IF_{2-Q}$) provide a bandpass filter for selecting a desired signal (603) in the RF signal and a band-stop filter for suppressing the image band (601) in the RF signal.

12. The method according to claim 11, wherein filtering the RF signal by the image rejection filter further comprises suppressing the image band according to a first bandwidth.

13. The method according to claim 12, wherein the band-stop filter suppresses the image band according to a second bandwidth, the second bandwidth being greater than the first bandwidth.

14. The method according to any of claims 11 to 13, wherein the received signal is the RF signal.

15. The method according to any of claims 11 to 14 further comprising: amplifying (804), by a low-noise amplifier, the received RF signal before filtering the RF signal.

**Patentansprüche**

1. Eine Vorrichtung (102, 202) zur Unterdrückung eines Bildbandes (601) in einem Hochfrequenzsignal, wobei die Vorrichtung Folgendes umfasst:

    ein Bildunterdrückungsfilter (130, 230);
    einen Oszillator (150, 250), der so konfiguriert ist, dass er ein Oszillatorsignal (LO1) erzeugt;
    einen Mischer (140, 240), der mit dem Bildunterdrückungsfilter und dem Oszillator gekoppelt ist, wobei der Mischer so konfiguriert ist, dass er ein empfangenes Eingangssignal in ein erstes Zwischenfrequenzsignal (IF1) auf der Grundlage des Oszillatorsignals (LO1) umwandelt;
    einen Frequenzteiler (160, 260), der so konfiguriert ist, dass er eine Vielzahl von Oszillatorsignalen in Quadratur zueinander (LO2-I, LO2-Q) erzeugt; und
    ein Translationsfilter (170, 270), das eine Vielzahl von passiven Mischern (171a, 171b, 271a, 271b) umfasst, die so konfiguriert sind, dass sie das erste Zwischenfrequenzsignal (IF1) in eine Vielzahl von zweiten Zwischenfrequenzsignalen in Quadratur zueinander (IF2-I, IF2-Q) basierend auf der Vielzahl von QuadraturOszillatorsignalen (LO2-I, LO2-Q) umwandeln; und eine Vielzahl von frequenzabhängigen Impedanzen (172a, 172b, 272a, 272b), die jeweils als eine Last mit einem Ausgang eines jeweiligen der Vielzahl von passiven Mischern gekoppelt sind, wobei:
    das Bildunterdrückungsfilter (130, 230) und das Translationsfilter (170, 270) so ausgelegt sind, dass sie zusammen ein Bandpassfilter zum Auswählen eines gewünschten Signals (603) in dem HF-Signal und ein Bandsperrfilter zum Unterdrücken des Bildbandes (601) in dem HF-Signal bilden.

2. Vorrichtung nach Anspruch 1, wobei ein Frequenzgang des Bildunterdrückungsfilters ein Unterdrückungsband mit einer ersten Bandbreite enthält.

3. Vorrichtung nach Anspruch 2, wobei ein Frequenzgang des Bandsperrfilters ein Unterdrückungsband mit einer zweiten Bandbreite umfasst, wobei die zweite Bandbreite größer als die erste Bandbreite ist.

4. Vorrichtung nach einem der vorhergehenden Ansprüche, wobei der mit dem Bildunterdrückungsfilter gekoppelte Mischer ein symmetrischer Mischer (300) ist und das empfangene Eingangssignal das HF-Signal ist.

5. Vorrichtung nach Anspruch 4, wobei das Bildunterdrückungsfilter (310) in dem symmetrischen Mischer (300) enthalten ist.

6. Vorrichtung nach einem der vorhergehenden Ansprüche, wobei jede der mehreren frequenzabhängigen Impedanzen einen Kondensator umfasst.

7. Vorrichtung nach einem der vorhergehenden Ansprüche, wobei die Vielzahl der Quadraturoszillatorsignale (LO2-I, LO2-Q) von dem Oszillatorsignal (LO1) durch Frequenzteilung abgeleitet werden.

8. Vorrichtung nach einem der Ansprüche 1 bis 6, wobei der Oszillator ein erster Oszillator (250) ist, der so konfiguriert ist, dass er ein erstes Oszillatorsignal (LO1) erzeugt, und die Vorrichtung ferner einen zweiten Oszillator (280) umfasst, der so konfiguriert ist, dass er ein zweites Oszillatorsignal (LO3) erzeugt, wobei der zweite Oszillator (280) mit dem Frequenzteiler (260) gekoppelt ist und die Vielzahl der Quadraturoszillatorsignale (LO2-I, LO2-Q) von dem zweiten Oszillatorsignal (LO3) durch Frequenzteilung abgeleitet werden.

9. Vorrichtung nach einem der vorhergehenden Ansprüche, wobei die Vorrichtung ferner einen rauscharmen Verstärker (120, 220) umfasst, der betriebsmäßig so gekoppelt ist, dass er das HF-Signal empfängt, und so konfiguriert ist, dass er das HF-Signal verstärkt.

10. Superheterodyn-Empfänger (100, 200) umfassend die Vorrichtung nach einem der vorangehenden Ansprüche.

11. Verfahren (800) zum Zurückweisen eines Bildbandes (601) in einem Hochfrequenzsignal, HF-Signal, wobei das Verfahren umfasst:

    Empfangen (802) des HF-Signals;
    Filtern (806) des HF-Signals durch ein Bildunterdrückungsfilter;

Erzeugen (808), durch einen Oszillator, eines Oszillatorsignals (LO1);

Umwandeln (810) eines empfangenen Signals in ein erstes Zwischenfrequenzsignal (IF1) basierend auf dem Oszillatorsignal (LO1) durch einen Mischer;

Erzeugen (812), durch einen Frequenzteiler, einer Vielzahl von Oszillatorsignalen in Quadratur zueinander (LO2-I, LO2-Q); und

Umwandeln (814), durch ein Translationsfilter, das eine Vielzahl von passiven Mischern (171a, 171b, 271a, 271b) und eine Vielzahl von frequenzabhängigen Impedanzen (172a, 172b, 272a, 272b) umfasst, die jeweils als eine Last mit einem Ausgang eines jeweiligen der Vielzahl von passiven Mischern gekoppelt sind, des ersten Zwischenfrequenzsignal (IF1) in eine Vielzahl von zweiten Zwischenfrequenzsignalen in Quadratur zueinander (IF2-I, IF2-Q) basierend auf der Vielzahl von Quadraturoszillatorsignalen (LO2-I, LO2-Q), wobei: die Filterung (806) des HF-Signals und die Umwandlung (814) des ersten Zwischenfrequenzsignals (IF1) in eine Vielzahl von zweiten Quadratur-Zwischenfrequenzsignalen (IF2-I, IF2-Q) ein Bandpassfilter zur Auswahl eines gewünschten Signals (603) in dem HF-Signal und ein Bandsperrfilter zur Unterdrückung des Bildbandes (601) in dem HF-Signal liefern.

12. Verfahren nach Anspruch 11, wobei die Filterung des HF-Signals durch das Bildunterdrückungsfilter ferner die Unterdrückung des Bildbandes gemäß einer ersten Bandbreite umfasst.

13. Verfahren nach Anspruch 12, wobei das Bandsperrfilter das Bildband gemäß einer zweiten Bandbreite unterdrückt, wobei die zweite Bandbreite größer als die erste Bandbreite ist.

14. Verfahren nach einem der Ansprüche 11 bis 13, wobei das empfangene Signal das HF-Signal darstellt.

15. Verfahren nach einem der Ansprüche 11 bis 14, ferner umfassend: Verstärken (804) des empfangenen HF-Signals durch einen rauscharmen Verstärker vor dem Filtern des HF-Signals.

**Revendications**

1. Dispositif (102, 202) pour rejeter une bande d'image (601) dans un signal radiofréquence, RF, le dispositif comprenant :

un filtre de réjection d'image (130, 230) ;

un oscillateur (150, 250) configuré pour générer un signal d'oscillateur (LO1) ;

un mélangeur (140, 240) couplé au filtre de réjection d'image et à l'oscillateur, le mélangeur étant configuré pour convertir un signal d'entrée reçu en un premier signal de fréquence intermédiaire (IF1) sur la base du signal d'oscillateur (LO1) ;

un diviseur de fréquence (160, 260) configuré pour générer une pluralité de signaux d'oscillateur en quadrature les uns avec les autres (LO2-I, LO2-Q) ; et

un filtre de translation (170, 270) comprenant une pluralité de mélangeurs passifs (171a, 171b, 271a, 271b) configurés pour convertir le premier signal de fréquence intermédiaire (IF1) en une pluralité de seconds signaux de fréquence intermédiaire en quadrature les uns avec les autres (IF2-I, IF2-Q) sur la base de la pluralité de signaux d'oscillateur en quadrature (LO2-I, LO2-Q) ; et une pluralité d'impédances dépendant de la fréquence (172a, 172b, 272a, 272b), chacune couplée en tant que charge à une sortie d'un mélangeur respectif de la pluralité de mélangeurs passifs, dans lequel :

le filtre de réjection d'image (130, 230) et le filtre de translation (170, 270) sont adaptés pour se combiner afin de fournir un filtre passe-bande pour sélectionner un signal souhaité (603) dans le signal RF et un filtre coupe-bande pour supprimer la bande d'image (601) dans le signal RF.

2. Le dispositif selon la revendication 1, dans lequel une réponse en fréquence du filtre de réjection d'image comprend une bande de suppression comprenant une première largeur de bande.

3. Le dispositif selon la revendication 2, dans lequel une réponse en fréquence du filtre coupe-bande comprend une bande de suppression comprenant une deuxième largeur de bande, la deuxième largeur de bande étant plus large à la première largeur de bande.

4. Le dispositif selon l'une quelconque des revendications précédentes, dans lequel le mélangeur couplé au filtre de réjection d'image est un mélangeur équilibré (300) et le signal d'entrée reçu constitue le signal RF.

**5.** Le dispositif selon la revendication 4, dans lequel le filtre de réjection d'image (310) est compris dans le mélangeur équilibré (300).

**6.** Le dispositif selon l'une quelconque des revendications précédentes, dans lequel chacune de la pluralité d'impédances dépendant de la fréquence comprend un condensateur.

**7.** Le dispositif selon l'une quelconque des revendications précédentes, dans lequel la pluralité de signaux d'oscillateur en quadrature (LO2-I, LO2-Q) sont dérivés du signal d'oscillateur (LO1) par division de fréquence.

**8.** Le dispositif selon l'une quelconque des revendications 1 à 6, dans lequel l'oscillateur est un premier oscillateur (250) configuré pour générer un premier signal d'oscillateur (LO1) et le dispositif comprend en outre un second oscillateur (280) configuré pour générer un second signal d'oscillateur (LO3), dans lequel le second oscillateur (280) est couplé au diviseur de fréquence (260) et la pluralité de signaux d'oscillateur en quadrature (LO2-I, LO2-Q) sont dérivés du second signal d'oscillateur (LO3) par division de fréquence.

**9.** Le dispositif selon l'une quelconque des revendications précédentes, dans lequel le dispositif comprend en outre un amplificateur à faible bruit (120, 220) couplé de manière opérationnelle pour recevoir le signal RF et configuré pour amplifier le signal RF.

**10.** Récepteur super-hétérodyne (100, 200) comprenant le dispositif selon l'une quelconque des revendications précédentes.

**11.** Procédé (800) pour rejeter une bande d'image (601) dans un signal radiofréquence, RF, le procédé comprenant :

la réception (802) du signal RF ;
le filtrage (806), par un filtre de réjection d'image, du signal RF ;
générer (808), par un oscillateur, un signal d'oscillateur (LO1) ;
convertir (810), par un mélangeur, un signal reçu en un premier signal de fréquence intermédiaire (IF1) basé sur le signal d'oscillateur (LO1) ;
générer (812), par un diviseur de fréquence, une pluralité de signaux d'oscillateur en quadrature les uns avec les autres (LO2-I, LO2-Q) ; et
convertir (814), par un filtre de translation comprenant une pluralité de mélangeurs passifs (171a, 171b, 271a, 271b) et une pluralité d'impédances dépendant de la fréquence (172a, 172b, 272a, 272b), chacune couplée en tant que charge à une sortie d'un mélangeur respectif de la pluralité de mélangeurs passifs, le premier signal de fréquence intermédiaire (IF1) à une pluralité de seconds signaux de fréquence intermédiaire en quadrature les uns avec les autres (IF2-I, IF2-Q) sur la base de la pluralité de signaux d'oscillateur en quadrature (LO2-I, LO2-Q), dans lequel :
le filtrage (806) du signal RF et la conversion (814) du premier signal de fréquence intermédiaire (IF1) en une pluralité de seconds signaux de fréquence intermédiaire en quadrature (IF2-I, IF2-Q) fournissent un filtre passe-bande pour sélectionner un signal souhaité (603) dans le signal RF et un filtre coupe-bande pour supprimer la bande d'image (601) dans le signal RF.

**12.** Le procédé selon la revendication 11, dans lequel le filtrage du signal RF par le filtre de réjection d'image comprend en outre la suppression de la bande d'image selon une première largeur de bande.

**13.** Le procédé selon la revendication 12, dans lequel le filtre coupe-bande supprime la bande d'image selon une seconde largeur de bande, la seconde largeur de bande étant plus large que la première largeur de bande.

**14.** Le procédé selon l'une quelconque des revendications 11 à 13, dans lequel le signal reçu constitue le signal RF.

**15.** Le procédé selon l'une quelconque des revendications 11 à 14 comprenant en outre : l'amplification (804), par un amplificateur à faible bruit, du signal RF reçu avant de filtrer le signal RF.

FIG. 1

EP 3 843 282 B1

FIG. 2

FIG. 3

EP 3 843 282 B1

FIG. 4

FIG. 5

FIG. 6

FIG. 7

EP 3 843 282 B1

800

FIG. 8

**REFERENCES CITED IN THE DESCRIPTION**

**Patent documents cited in the description**

- GB 2350953 A